# EUROPÄISCHE PATENTSCHRIFT

(11) **EP 0 840 673 B1**
(45) Veröffentlichungstag und Bekanntmachung des Hinweises auf die Patenterteilung: **12.09.2001**
(21) Anmeldenummer: 96916088.6
(22) Anmeldetag: 15.05.1996
(51) Int. Cl.: B29C 45/16, F16B 21/07, B01D 35/30

(54) **BEFESTIGUNGSELEMENT**
SECURING COMPONENT
ELEMENT DE FIXATION

(30) Priorität: 24.07.1995 DE 19526934
(43) Veröffentlichungstag der Anmeldung: 13.05.1998
(73) Patentinhaber: FILTERWERK MANN & HUMMEL GmbH, 71631 Ludwigsburg (DE)
(72) Erfinder: RIEGER, Mario, D-71691 Freiberg (DE)
(74) Vertreter: Voth, Gerhard, Dipl.-Ing.
(86) Internationale Anmeldenummer: EP9602089
(87) Internationale Veröffentlichungsnummer: WO9703801

(56) Entgegenhaltungen:
- DE-A- 3 807 797
- GB-A- 2 185 063
- US-A- 5 154 823

## Beschreibung

Die Erfindung betrifft ein Befestigungselement für ein Filtergehäuse an einer Befestigungsstruktur nach dem Oberbegriff des Hauptanspruchs.

Aus dem Stand der Technik sind eine Vielzahl von Befestigungselementen bekannt. Die einfachste Art ist eine Schraubverbindung. Diese hat jedoch den Nachteil, daß zusätzliche Elemente wie Schraube und Mutter erforderlich sind und außerdem ein hoher Montageaufwand nötig ist.

Es ist auch bekannt, ein Gehäuse mit einer Steckverbindung an einer Befestigungsstruktur anzuordnen. Hierzu ist an dem Gehäuse beispielsweise ein Bolzen vorgesehen, der in eine entsprechende Öffnung der Befestigungsstruktur eingerastet wird. Ein Nachteil dieser Anordnung ist jedoch die hohe Toleranzempfindlichkeit. Außerdem sind bei der Herstellung mehrere Arbeitsschritte erforderlich.

Aus der DE 38 07 797 ist ein Steckverbindungsgehäuse und ein Verfahren zur Herstellung desselben beschrieben. Bei diesem Gehäuse geht es um die Herstellung einer ringförmigen Dichtung, die eine wasser- und luftdichte Kapselung eines elektrischen Steckers ermöglicht. Hierzu wird in ein bereits fertiges Gehäuse ein Dichtungsmaterial im Spritzgießverfahren eingespritzt. Die derart gebildete Dichtung dient dazu, einen Gegenstecker mit den oben erwähnten Dichteigenschaften zu koppeln. Eine vibrationsarme Kopplung bzw. eine akustische Endkopplung ist jedoch mit diesem bekannten System nicht möglich.

Der Erfindung liegt daher die Aufgabe zugrunde, ein Befestigungselement für ein Filtergehäuse zu schaffen, das einfach und kostengünstig herstellbar ist und ferner Fertigungstoleranzen bis zu einem bestimmten Maß verkraftet sowie gute akustische Entkopplung bietet.

Diese Aufgabe wird ausgehend von dem Oberbegriff des Hauptanspruchs durch dessen kennzeichnenden Merkmale gelöst.

Der wesentliche Vorteil der Erfindung besteht darin, daß das Befestigungselement mit einem gummielastischen Element ausgerüstet ist, welches in 2K-Spritzgießtechnik hergestellt ist. Ein solches Element läßt sich in einem Arbeitsgang beim Herstellen des Kunststoffgehäuses an diesem anordnen. Eine Nachbearbeitung oder ein zusätzlicher Arbeitsschritt ist nicht erforderlich.

TPE läßt sich spritzgießtechnisch verarbeiten und hat gummielastische Eigenschaften, die je nach Zusammensetzung an den Anwendungsfall angepaßt werden können.

Eine weitere vorteilhafte Ausgestaltung sieht vor, das gummielastische Element so zu gestalten, daß eine große toleranzausgleichende Wirkung erzielt wird.

Dies kann beispielsweise dadurch erfolgen, daß dieses Element eine Art Faltenbildung zeigt oder daß Teile des Elements nach Art eines beidseitig eingespannten Biegebalkens ausgestaltet sind.

Eine vorteilhafte Weiterbildung sieht vor, das gummielastische Element mit einer vibrationsdämpfenden Körperstruktur zu versehen. Auch hier ist die Verwendung von TPE von Vorteil, da dieses Material eine hohe Dämpfungseigenschaft aufweist und damit Vibrationen, die von der Befestigungsstruktur verursacht werden, nicht in das Gehäuse, insbesondere das Filtergehäuse eingeleitet werden. Solche Vibrationen entstehen beispielsweise bei einem Kraftfahrzeug. Insbesondere die Komponenten des Motors wie Filtergehäuse und sonstige periphere Elemente müssen von diesen Vibrationen wirksam entkoppelt werden. Hierzu ist das Befestigungselement geeignet.

Zum Fixieren des Gehäuses an der Befestigungsstruktur wird das Befestigungselement an einem entsprechenden Gegenstück eingerastet. Dieses kann beispielsweise ein Schraubbolzen oder ein Schweißbolzen sein. Selbstverständlich sind auch andere Befestigungselemente denkbar, wie z.B. Laschen. Für eine Befestigung mittels eines Schraubbolzens ist es zweckmäßig, in dem gummielastischen Element eine Metallbuchse anzuordnen, welche die wirksame Schraublänge definiert.

Eine vorteilhafte Variante der Erfindung sieht vor, das Befestigungselement mit einer steckbaren Kontur in Form eines Bolzens auszubilden. Dieser wird in eine Öffnung der Befestigungsstruktur eingesteckt. Auch hier lassen sich verschiedene Konturen erzielen, die sowohl eine toleranzausgleichende als auch eine vibrationsdämpfende Wirkung zeigen.

Diese und weitere Merkmale von bevorzugten Weiterbildungen der Erfindung gehen außer aus den Ansprüchen auch aus der Beschreibung und den Zeichnungen hervor, wobei die einzelnen Merkmale jeweils für sich allein oder zu mehreren in Form von Unterkombinationen bei der Ausführungsform der Erfindung und auf anderen Gebieten verwirklicht sein und vorteilhafte sowie für sich schutzfähige Ausführungen darstellen können, für die hier Schutz beansprucht wird.

Die Erfindung wird nachfolgend anhand von Ausführungsbeispielen näher erläutert. Es zeigt:
- Figur 1: eine Schnittdarstellung eines Befestigungselements in 2K-Technik,
- Figur 2: eine Schnittdarstellung eines Befestigungselements mit schwingungsdämpfenden Eigenschaften,
- Figur 3: die Schnittdarstellung eines Befestigungselements mit einem vergrößerten Federweg zur Schwingungsdämpfung,
- Figur 4: Schnitt- und Draufsichtdarstellung eines Befestigungselements in einfacher Laschenbauweise,
- Figur 5: die Schnittdarstellung eines einfachen Befstigungselements mit Federwirkung zur Schwingungsdämpfung,
- Figur 6: einen Steckhalter in Axial- und Radialschnitt,
- Figur 7: einen Steckhalter in einer Ausführungsvariante,
- Figur 8: ein Gehäuse mit Befestigungselementen.

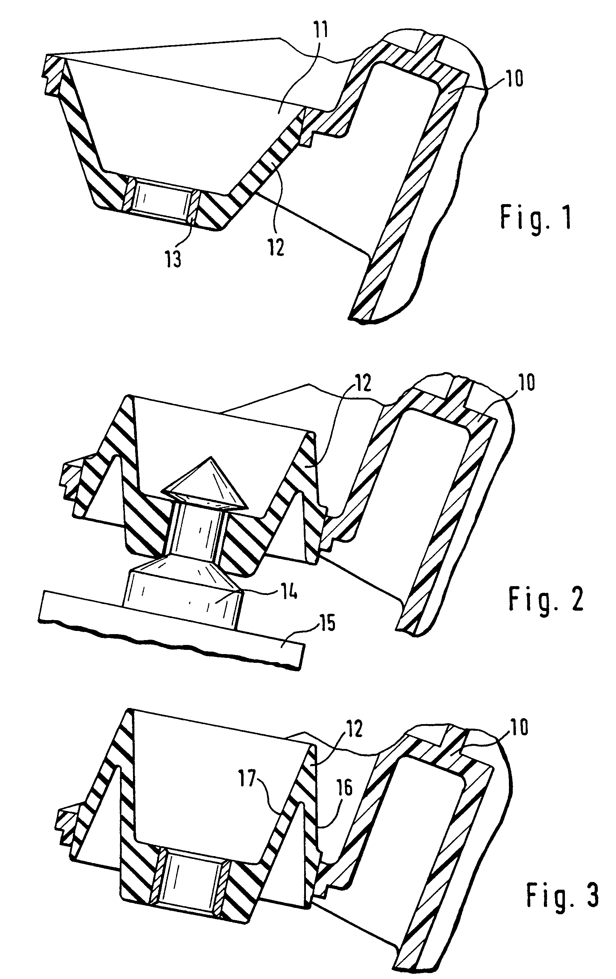

Die Schnittdarstellung eines Befestigungselements gemäß Figur 1 zeigt ein Teil eines Kunststoffgehäuses 10, in welchem in einer Öffnung 11 ein Befestigungselement, d. h. ein gummielastisches Element 12 angeordnet ist. Dieses Element ist in 2K-Spritzgießtechnik hergestellt, d. h. bei diesem Verfahren wir zuerst die erste Komponente, d. h. das Kunststoffgehäuse, gegossen, anschließend in der Spritzgießform ein Schieber geöffnet. Dieser Schieber gibt den Hohlraum für das gummielastische Element frei. In diesen Hohlraum wird die Masse für das Element eingespritzt. Nach dem Erkalten beider Elemente bzw. beider Komponenten kann das komplette Gehäuse aus der Spritzgießform entnommen werden.

Das Befestigungselement 12 ist mit einer Metallhülse 13 versehen. Selbstverständlich ist eine solche Hülse nur dann erforderlich, wenn sie in Wirkverbindung mit einem Gewindebolzen o. ä. steht.

Figur 2 zeigt wiederum einen Teil des Kunststoffgehäuses 10. An diesem ist das Befestigungselement 12 in 2K-Spritzgießtechnik angeordnet. Dieses weist eine Form auf, die besonders geeignet ist, Schwingungen, die über den Befestigungsbolzen 14 von der Befestigungsstruktur 15 eingeleitet werden, wirksam abzudämpfen. Außerdem ist der Aufbau des Befestigungselements 12 geeignet, Lagetoleranzen zwischen dem Befestigungsbolzen 14 und dem Kunststoffgehäuse 10 auszugleichen.

Figur 3 zeigt in einer Schnittdarstellung ein Befestigungselement mit vergrößertem Federweg bzw. weicherer Abstimmung. Auch hier ist das Kunststoffgehäuse 10 in einem Ausschnitt sichtbar. An diesem ist das Befestigungselement 12 angeordnet. Dieses Befestigungselement weist zwei lange Flankenbereiehe 16, 17 auf, die einerseits eine sehr hohe Lagekompensation ermöglichen, andererseits sehr gute Schwingungsdämpfungseigenschaften aufweisen.

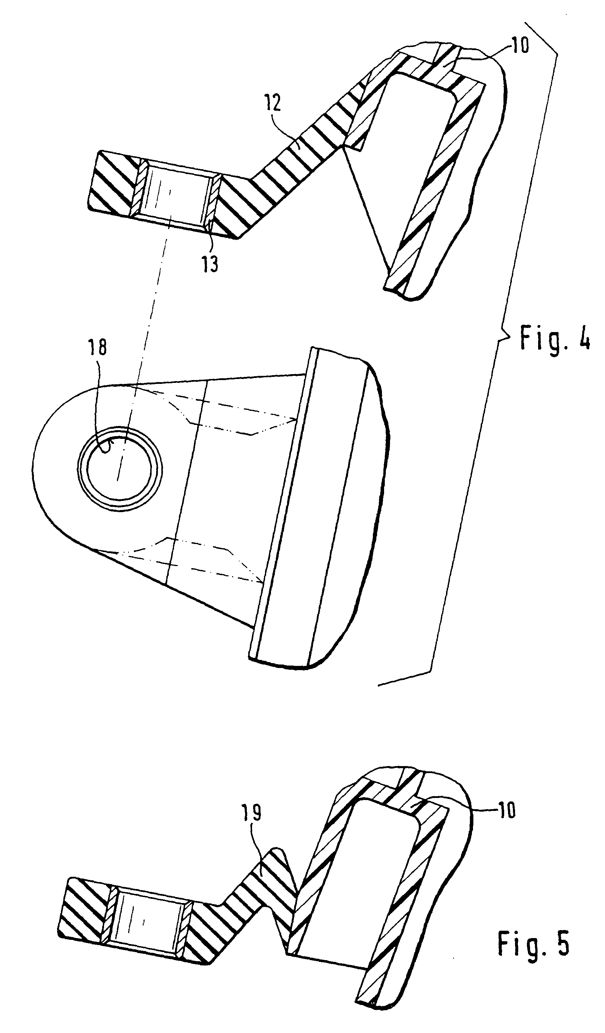

Figur 4 zeigt in einer Schnitt- und in einer Draufsichtdarstellung ein Befestigungselement in einfacher Laschenbauweise. An dem Kunststoffgehäuse 10 ist das Befestigungselement 12 nach Art einer Lasche angespritzt. Die Draufsicht zeigt, daß diese Lasche im vorderen Bereich ein Auge aufweist, welches mit einer Bohrung 18 zur Aufnahme eines hier nicht dargestellten Befestigungsbolzens ausgestattet ist. Die Verbindung zwischen dem Befestigungselement 12 und dem Kunststoffgehäuse kann beliebig ausgestaltet werden und läßt sehr hohe Kräfte zu.

In Figur 5 ist an dem Kunststoffgehäuse 10 ein Befestigungselement angeordnet, das eine einfache Lasche darstellt, allerdings zusätzlich mit einem abgewinkelten Befestigungsbereich 19. Dies ermöglicht eine verbesserte Federwirkung zur Schwingungsdämpfung.

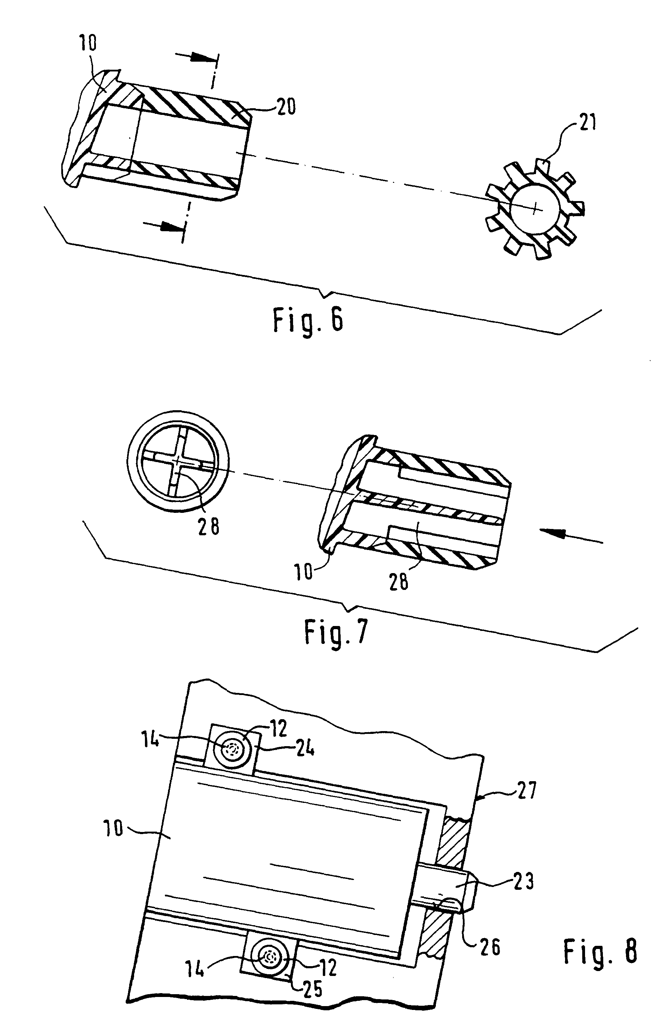

Figur 6 zeigt einen Steckhalter. In dem Axialschnitt ist zu erkennen, daß an dem Kunststoffgehäuse 10 dieser Steckhalter nach Art eines hohlzylindrischen Elements 20 ausgebildet ist. Der Radialschnitt zeigt die Struktur dieses hohlzylindrischen Elements. Dieses ist außen mit Stegen 21 ausgestattet. Zur Befestigung des Kunststoffgehäuses 10 an einer Befestigungsstruktur wird das Element in eine Aufnahmebohrung eingeführt.

Figur 7 zeigt eine Variante dieses Befestigungselements. Während im Axialschnitt die Integration desselben an dem Kunststoffgehäuse 10 zu sehen ist, zeigt der Radialschnitt, daß die Oberfläche keine Rippen aufweist. Zur Absicherung der Montage ist eine Kreuzrippe 28 vorgesehen. Diese verhindert eine Fehlmontage, d. h. ein Quetschen des Puffers an dem Gehäuse bzw. Blech ist nicht möglich. Die Kreuzrippe sorgt dafür, daß das Befestigungselement auch in die Befestigungsbohrung gelangt.

In Figur 8 ist der Komplettaufbau gezeigt. Ein Kunststoffgehäuse 10 ist mit einem Steckhalter 23 und zwei Befestigungslaschen 24, 25 versehen. Mittels des Steckhalters 23 wird das Kunststoffgehäuse in eine Öffnung 26 der Befestigungsstruktur 27 eingesteckt. An der Befestigungsstruktur sind im Bereich der Befestigungslaschen 24, 25 Befestigungsbolzen vorgesehen. Das jeweils in der Befestigungslasche 24, 25 integrierte Befestigungselement 12 wird an dem Befestigungsbolzen fixiert.

Die Montage des Kunststoffgehäuses wird damit sehr stark vereinfacht und erfolgt im wesentlichen durch einen einzigen Handgriff, nämlich das Einstecken des Gehäuses mittels des Steckhalters und das Niederdrücken auf die Befestigungsbolzen 14.

## Patentansprüche

1. Befestigungselement für ein Filtergehäuse an einer Befestigungsstruktur (27), wobei an dem Gehäuse (10) ein Haltebereich vorgesehen ist, **dadurch gekennzeichnet, daß** in diesem Bereich ein in 2K-Spritztechnik hergestelltes gummielastisches Element (12) angeordnet ist, welches mit der Befestigungsstruktur (27) in Verbindung steht, wobei das gummielastische Element (12) eine toleranzausgleichende Körperstruktur aufweist.

2. Befestigungselement nach Anspruch 1, **dadurch gekennzeichnet, daß** das gummielastische Element (12) ein Elastomer, insbesondere ein TPE ist.

3. Befestigungselement nach einem der vorherigen Ansprüche, **dadurch gekennzeichnet, daß** das gummielastische Element (12) eine vibrationsdämpfende Körperstruktur aufweist.

4. Befestigungselement nach einem der vorherigen Ansprüche, **dadurch gekennzeichnet, daß** in dem gummielastischen Element (12) eine Metallhülse (13) angeordnet ist.

5. Befestigungselement nach einem der vorherigen Ansprüche, **dadurch gekennzeichnet, daß** es eine in eine Öffnung (26) der Befestigungsstruktur (27) steckbare Kontur aufweist.

## Claims

1. Securing means for a filter housing on a securing structure (27), a retaining region being provided on the housing (10), **characterised in that** a resilient element (12) is disposed in this region, which element is produced by the two-component injection moulding technique and communicates with the securing structure (27), the resilient element (12) having a body structure which compensates for tolerances.

2. Securing means according to claim 1, **characterised in that** the resilient element (12) is an elastomer, more especially a TPE.

3. Securing means according to one of the previous claims, **characterised in that** the resilient element (12) has a vibration-damping body structure.

4. Securing means according to one of the previous claims, **characterised in that** a metal sleeve (13) is disposed in the resilient element (12).

5. Securing means according to one of the previous claims, **characterised in that** it has a configuration which can be inserted into an opening (26) of the securing structure (27).

## Revendications

1. Elément de fixation pour un boîtier de filtre sur une structure de fixation (27), le boîtier (10) comportant une zone de retenue,
**caractérisé en ce que**
dans cette zone est disposé un élément élastique en caoutchouc (12), réalisé en technique d'injection à 2 composants, et qui est relié à la structure de fixation (27), l'élément élastique en caoutchouc (12) présentant une structure de forme à compensation de tolérances.

2. Elément de fixation selon la revendication 1,
**caractérisé en ce que**
l'élément élastique en caoutchouc (12) est un élastomère en particulier un TPE.

3. Elément de fixation selon l'une des revendications précédentes,
**caractérisé en ce que**
l'élément élastique en caoutchouc (12) présente une structure de forme d'amortisseur de vibrations.

4. Elément de fixation selon l'une des revendications précédentes,
**caractérisé en ce que**
dans l'élément élastique en caoutchouc (12) est montée une douille métallique (13).

5. Elément de fixation selon l'une des revendications précédentes,
**caractérisé en ce qu'**
il présente un contour encastrable dans une ouverture (26) de la structure de fixation (27).
